(19)

Europäisches
Patentamt
European
Patent Office
Office européen
des brevets

(11) **EP 4 620 933 A1**

(12) **EUROPEAN PATENT APPLICATION**
published in accordance with Art. 153(4) EPC

(43) Date of publication:
**24.09.2025 Bulletin 2025/39**

(21) Application number: **23891650.6**

(22) Date of filing: **16.11.2023**

(51) International Patent Classification (IPC):
**$C03C\ 19/00$** (2006.01)   **$C03C\ 17/34$** (2006.01)
**$G09F\ 9/00$** (2006.01)

(52) Cooperative Patent Classification (CPC):
**C03C 17/34; C03C 19/00; G09F 9/00**

(86) International application number:
**PCT/JP2023/041250**

(87) International publication number:
**WO 2024/106503 (23.05.2024 Gazette 2024/21)**

(84) Designated Contracting States:
**AL AT BE BG CH CY CZ DE DK EE ES FI FR GB
GR HR HU IE IS IT LI LT LU LV MC ME MK MT NL
NO PL PT RO RS SE SI SK SM TR**
Designated Extension States:
**BA**
Designated Validation States:
**KH MA MD TN**

(30) Priority:   **18.11.2022   JP 2022185227**

(71) Applicant: **AGC INC.**
**Chiyoda-ku,**
**Tokyo 1008405 (JP)**

(72) Inventors:
• **KAWATA Toru**
**Tokyo 100-8405 (JP)**
• **MASUDA Yuichi**
**Tokyo 100-8405 (JP)**
• **ISHINO Akihisa**
**Tokyo 100-8405 (JP)**
• **ONO Takeaki**
**Tokyo 100-8405 (JP)**
• **HOKARI Ryou**
**Tokyo 100-8405 (JP)**

(74) Representative: **Müller-Boré & Partner**
**Patentanwälte PartG mbB**
**Friedenheimer Brücke 21**
**80639 München (DE)**

(54) **GLASS ARTICLE, ONBOARD DISPLAY DEVICE, AND METHOD FOR MANUFACTURING SAME**

(57)    A glass article according to the present invention has a first main surface, a second main surface, and an end face connecting the first main surface and the second main surface. The end face includes a side surface section, and a curved first chamfered part connecting the side surface section and the first main surface. An antireflection layer is provided on the first main surface and the first chamfered part. The average value $Ra_1$ of the arithmetic mean roughness of the surface of the glass article is 0.20 $\mu$m or less in a region where the angle formed between the first chamfered part and the first main surface is greater than 0° and at most 40°. The average value $Ra_3$ of the arithmetic mean roughness of the surface of the glass article is 0.30 $\mu$m or more on the side surface section and in a region where the angle formed between the first chamfered part and the first main surface is greater than 80°. The average value $Ra_2$ of the arithmetic mean roughness of the surface of the glass article in a region where the angle formed between the first chamfered part and the first main surface is 60° to 80° satisfies expression (1): $0.2 \leq (Ra_2 - Ra_1) / (Ra_3 - Ra_1) \leq 0.8$.

*FIG. 2*

**Description**

TECHNICAL FIELD

The present invention relates to a glass article, an in-vehicle display device, and a production method therefor.

BACKGROUND ART

In the related art, a glass article including a glass, an antireflection film disposed on a first main surface of the glass, and a frame-shaped printed portion disposed on a second main surface of a glass plate is used as a cover glass in a display device such as an in-vehicle display device. In recent years, in such a cover glass in an in-vehicle display device, from the viewpoint of improving impact resistance and design properties, a shape in which an end portion on a side close to the first main surface is chamfered is required. At this time, it is known that in the case where the chamfered portion has a curved surface, a phenomenon that the end portion appears red (hereinafter, referred to as red discoloration or the like) occurs (see, for example, Patent Literature 1).

Since red is a warning color, such red discoloration is not preferred by a user of the display device, and the user of the display device may erroneously recognize the red discoloration as an abnormality or a failure of the display device, for example. Therefore, it is required to avoid the red discoloration. For example, in Patent Literature 1, the red discoloration of the end portion is avoided by adjusting a configuration of the antireflection layer.

CITATION LIST

PATENT LITERATURE

Patent Literature 1: WO2021/161879

SUMMARY OF INVENTION

TECHNICAL PROBLEM

However, in the technique described in Patent Literature 1, since it is necessary to adjust the configuration of the antireflection layer itself, there is a possibility that a design width of the antireflection layer is narrowed, and an alternative proposal has been required.

The present invention has been made in view of the above problems, and an object thereof is to provide a glass article capable of preventing red discoloration of an end portion by a new method different from that in Patent Literature 1.

SOLUTION TO PROBLEM

A glass article according to the present invention includes: a first main surface; a second main surface; and an end surface connecting the first main surface and the second main surface, in which the end surface includes a side surface portion and a first chamfered portion having a curved surface shape connecting the side surface portion and the first main surface, the first main surface and the first chamfered portion include an antireflection layer, in a region where an angle formed between the first chamfered portion and the first main surface is greater than 0° and 40° or less, an average value $Ra_1$ of an arithmetic mean roughness Ra on a surface of the glass article is 0.20 $\mu$m or less, in a region where the angle formed between the first chamfered portion and the first main surface is greater than 80° and in the side surface portion, an average value $Ra_3$ of the arithmetic mean roughness Ra on the surface of the glass article is 0.30 $\mu$m or more, and in a region where the angle formed between the first chamfered portion and the first main surface is 60° or more and 80° or less, an average value $Ra_2$ of the arithmetic mean roughness Ra on the surface of the glass article satisfies the following expression (1).

$$0.2 \leq (Ra_2 - Ra_1)/(Ra_3 - Ra_1) \leq 0.8 \qquad (1)$$

ADVANTAGEOUS EFFECTS OF INVENTION

With the glass article according to the present invention, it is possible to provide a glass article in which red discoloration of an end portion is prevented.

BRIEF DESCRIPTION OF DRAWINGS

[FIG. 1] FIG. 1 is a schematic diagram illustrating an in-vehicle display device.

[FIG. 2] FIG. 2 is a schematic diagram illustrating a cross section of a glass article according to the present embodiment.

[FIG. 3] FIG. 3 is a schematic diagram illustrating the cross section of the glass article according to the present embodiment.

[FIG. 4] FIG. 4 is a schematic diagram illustrating the cross section of the glass article according to the present embodiment.

[FIG. 5] FIG. 5 includes schematic diagrams each illustrating a method for producing the glass article according to the present embodiment. (A) of FIG. 5 is a diagram schematically illustrating a state in which a first chamfered portion is formed by grinding, and (B) of FIG. 5 is a diagram schematically illustrating a state in which the first chamfered portion is polished.

[FIG. 6] FIG. 6 is a graph showing a surface roughness on an end surface of glasses in Examples 1 to 4.

[FIG. 7] FIG. 7 is a graph showing a surface roughness on an end surface of glasses in Examples 5 to 7.

DESCRIPTION OF EMBODIMENTS

Hereinafter, embodiments of the present invention are described in detail with reference to the drawings.

<In-vehicle Display Device>

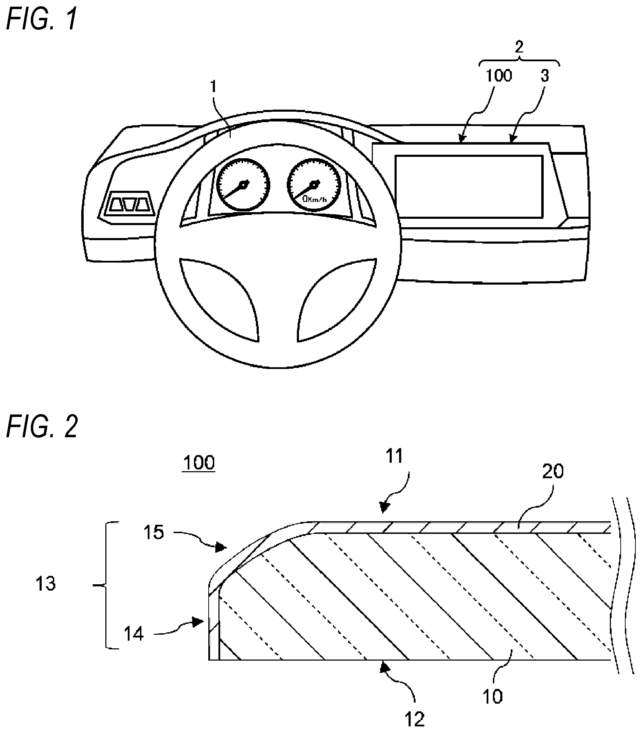

FIG. 1 is a schematic diagram illustrating an in-vehicle display device in the case where a glass article according to the present embodiment is used as a cover material of the in-vehicle display device. As illustrated in FIG. 1, an in-vehicle display device 2 is a display device provided in a vehicle, and is provided in front of a steering shaft 1 in the vehicle, for example. The in-vehicle display device 2 includes a display panel 3 and a glass article 100. The display panel 3 displays, for example, a car navigation screen, and an image of various meters such as a speed meter, a start button, and the like. The glass article 100 is used as a cover material (display cover material) on a front surface of the display panel 3. However, the configuration in FIG. 1 is an example, and the in-vehicle display device to which the glass article 100 is applied may have any configuration. In addition, the glass article 100 is not limited to being used as a cover material on the surface of the in-vehicle display device, but may be used for any application, such as a cover material of a display device of a smartphone or the like.

<Glass Article>

FIG. 2 is a schematic diagram illustrating a cross section of the glass article 100. As illustrated in FIG. 2, the glass article 100 in the present embodiment includes a glass 10, a first main surface 11, a second main surface 12, and an end surface 13 connecting the first main surface 11 and the second main surface 12. The end surface 13 includes a side surface portion 14 and a first chamfered portion 15 having a curved surface shape connecting the side surface portion 14 and the first main surface 11. Note that, in the end surface 13, the side surface portion 14 and the first chamfered portion 15 having a shape as illustrated in FIG. 2 may be formed over the entire circumference of the glass article 100, or may be formed only in a part of the circumference. An antireflection layer 20 is formed on a surface of the glass 10 on the first main surface 11 and the first chamfered portion 15.

At this time, in a region where an angle formed between the first chamfered portion 15 and the first main surface 11 is greater than 0° and 40° or less, an average value $Ra_1$ of an arithmetic mean roughness Ra on the surface of the glass article 100 is 0.20 $\mu$m or less, in a region where the angle formed between the first chamfered portion 15 and the first main surface 11 is greater than 80° and in the side surface portion 14, an average value $Ra_3$ of the arithmetic mean roughness Ra on the surface of the glass article 100 is 0.30 $\mu$m or more, and in a region where the angle formed between the first chamfered portion 15 and the first main surface 11 is 60° or more and 80° or less, an average value $Ra_2$ of the arithmetic mean roughness Ra on the surface of the glass article 100 satisfies the following expression (1).

$$0.2 \le (Ra_2 - Ra_1)/(Ra_3 - Ra_1) \le 0.8 \qquad (1)$$

The first chamfered portion 15 is formed by chamfering the end surface 13 of the glass 10, and the side surface portion 14 is a non-chamfered region of the end surface 13. In the case where the glass article 100 is assembled as a cover glass to the in-vehicle display device 2, since the first chamfered portion 15 is also visually recognized by a driver, the first chamfered portion 15 of the glass 10 may be polished to reduce the surface roughness for the purpose of improving aesthetics. Note that, the surface shape of the glass article 100 in which the antireflection layer 20 and other decorative layers are provided on the surface of the glass 10 follows the surface shape of the glass 10, and the arithmetic mean roughness of the surfaces of the glass article 100 and the glass 10 substantially matches each other.

At this time, in a chamfering method in the related art to be described in the following (polishing step), the entire end surface 13 including the side surface portion 14 is generally polished to reduce the surface roughness. However, in the case where the first chamfered portion 15 is formed to have a curved surface shape and the surface roughness of the end surface 13 is reduced, there is a problem that red discoloration of the end portion inevitably occurs.

As a result of investigation, the inventors of the present invention have found that when in the region where the angle formed relative to the first main surface 11, which is most easily visually recognized by the driver, is greater than 0° and 40° or less, the average value $Ra_1$ of the arithmetic mean roughness Ra on the surface of the glass article 100 is set to 0.20 μm or less, the aesthetics viewed from the driver can be improved, and when in the region where the angle formed between the first chamfered portion 15 and the first main surface 11 is greater than 80° and in the side surface portion 14, the average value $Ra_3$ of the arithmetic mean roughness Ra on the surface of the glass article 100 is set to 0.30 μm or more, red discoloration of the end surface 13 can be prevented without impairing the aesthetics.

Hereinafter, a mechanism that can prevent the red discoloration is described. Note that, the mechanism that can prevent the red discoloration is not limited to the following, and may be based on a principle other than the following principle.

In the case where the surface roughness of the glass article 100 is small on the end surface 13, scattering by the surface roughness is less likely to occur, and thus the driver particularly strongly observes specularly reflected light among the light incident on the end surface 13. Here, the color tone of the reflected light on the first main surface is preferably white. At this time, when the configuration of the antireflection layer is adjusted such that the color tone of the reflected light on the first main surface is white, the color tone of the specularly reflected light on the end surface 13 becomes red, and red is strongly recognized, thereby causing red discoloration.

On the other hand, when the surface roughness of the glass article 100 is increased on the end surface 13, the light incident on the end surface 13 is scattered. Therefore, the driver observes the light obtained by scattering and summing the light incident on the end surface 13 from various angles, and in this case, the color tone of the reflected light is brought close to white.

Therefore, in the case where the surface roughness is increased in the region where the angle formed between the first chamfered portion 15 and the first main surface 11 is greater than 80° and in the side surface portion 14, which are relatively difficult to be visually recognized by the driver, the scattered light is increased, and the color tone of the end portion can be brought close to white.

However, in the case where the surface roughness on the end surface 13 rapidly changes, a boundary portion is visually recognized linearly. Therefore, in the region where the angle formed between the first chamfered portion 15 and the first main surface 11 is 60° or more and 80° or less, the surface roughness is set to be an intermediate surface roughness between that of the region where the angle formed is 40° or less and that of the region where the angle formed is greater than 80°.

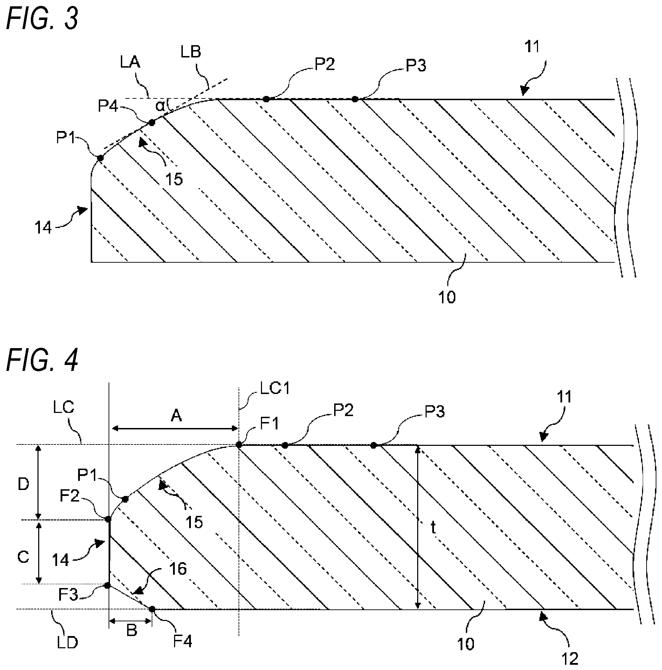

Here, a method of determining the angle formed between the first chamfered portion 15 and the first main surface 11 is described with reference to FIG. 3. Note that, in FIG. 3, the antireflection layer is omitted. For example, an angle formed at an arbitrary point P4 is determined by the following method.

A cross-sectional view of the glass article 100, that is, a cross section of the glass article 100, is observed from a direction perpendicular to a thickness direction by using a digital microscope (for example, VHK-6000 manufactured by KEYENCE CORPORATION).

At this time, an arbitrary point on the side surface portion 14 and the first chamfered portion 15 is defined as P1, an intersection point between an arc having a radius of 3 mm centered on the point P1 and the first main surface 11 is defined as a position P2, an intersection point between an arc having a radius of 5 mm centered on the point P1 and the first main surface 11 is defined as a position P3, and a straight line connecting the position P2 and the position P3 is defined as a reference line LA.

The angle formed at the arbitrary point P4 is defined as an angle $\alpha$ between a tangent line LB on the first chamfered portion 15 at the arbitrary point P4 and the reference line LA.

According to this method, an angle formed between a point on the first chamfered portion 15 and the first main surface 11 can be defined not only in the case where the first main surface 11 is flat, but also in the case where the first main surface 11 is curved.

Next, the arithmetic mean roughness Ra on the surface of the glass article 100 is determined by using, for example, the following method.

The arithmetic mean roughness Ra is defined in accordance with JIS B 0601:2.

The end surface 13 of the glass article 100 is measured by using a laser microscope (for example, LEXT OLS5000 manufactured by Olympus Corporation, 50x lens in use). At this time, the glass article 100 is installed such that a perpendicular line at the measurement point on the end surface 13 coincides with the optical axis of the lens of the laser microscope.

A region of 256 $\mu$m in length $\times$ 256 $\mu$m in width is measured, the arithmetic mean roughness Ra of 10 lines spaced 5 $\mu$m apart along the entire horizontal length of a region of 50 $\mu$m in length $\times$ 256 $\mu$m in width at a vertical center of the measurement region is calculated, and the average value is used as the roughness at that measurement point.

For the average value of the arithmetic mean roughness Ra in each region, the arithmetic mean roughness Ra is calculated by the above method for a plurality of measurement points in each region, and their average value is used. For example, in the region where the angle formed between the first chamfered portion 15 and the first main surface 11 is greater than 0° and 40° or less, measurements may be taken at 10°, 20°, 30°, and 40°, and the average value of the arithmetic mean roughness Ra at each measurement point may be calculated, that is, the measurement may be taken at one point every 10° angle within the region, and the average of the measurement points may be used.

Note that, in the case where the glass article 100 according to the present embodiment is used as a cover material of the in-vehicle display device 2, it is preferable that at least a part of the first chamfered portion 15 remains exposed in a state in which the glass article 100 is attached as the cover material of the in-vehicle display device 2.

At this time, in the glass article 100, it is preferable that, among the regions of the first chamfered portion 15 in the exposed state, arbitrary 10 points that are substantially uniformly dispersed are measured, and five or more of the 10 points satisfy the requirement of the arithmetic mean roughness Ra in the present invention. In the case where five or more of the 10 points satisfy the requirements in the present invention, it is possible to significantly reduce the user's perception of red discoloration at the end portion of the display device.

Hereinafter, a preferred aspect of the glass article 100 is described in detail.

(End Surface 13)

In the region where the angle formed between the first chamfered portion 15 and the first main surface 11 is greater than 0° and 40° or less, the average value $Ra_1$ of the arithmetic mean roughness Ra on the surface of the glass article 100 is 0.20 $\mu$m or less, preferably 0.15 $\mu$m or less, and more preferably 0.10 $\mu$m or less. Within the above range, the aesthetics of the end surface 13 viewed from the driver can be improved.

Here, in the region where the angle formed between the first chamfered portion 15 and the first main surface 11 is 60° or more and 80° or less, the average value $Ra_2$ of the arithmetic mean roughness Ra on the surface of the glass article 100 satisfies the following expression (1) with respect to the average value $Ra_1$ of the arithmetic mean roughness Ra on the surface of the glass article 100 in the region where the angle formed between the first chamfered portion 15 and the first main surface 11 is greater than 0° and 40° or less and the average value $Ra_3$ of the arithmetic mean roughness Ra on the surface of the glass article 100 in the region where the angle formed between the first chamfered portion 15 and the first main surface 11 is greater than 80° and in the side surface portion 14.

$$0.2 \leq (Ra_2 - Ra_1)/(Ra_3 - Ra_1) \leq 0.8 \qquad (1)$$

Accordingly, the region where the angle formed is 60° or more and 80° or less can be a transient region having an intermediate surface roughness between that of the region where the angle formed is 40° or less and that of the region where the angle formed is 80° or more, so that a boundary region is not visually recognized linearly, and the aesthetics can be improved.

Preferably, in the region where the angle formed between the first chamfered portion 15 and the first main surface 11 is 60° or more and 80° or less, the average value $Ra_2$ of the arithmetic mean roughness Ra on the surface of the glass article 100 is greater than 0.10 $\mu$m and smaller than 0.35 $\mu$m.

More preferably, in the region where the angle formed between the first chamfered portion 15 and the first main surface 11 is 60° or more and 80° or less, the average value $Ra_2$ of the arithmetic mean roughness Ra on the surface of the glass article 100 is greater than 0.10 $\mu$m and smaller than 0.30 $\mu$m.

Note that, in a region where the angle formed between the first chamfered portion 15 and the first main surface 11 is greater than 40° and 80° or less, an average value of the arithmetic mean roughness Ra on the surface of the glass article 100 is preferably greater than 0.10 $\mu$m and smaller than 0.35 $\mu$m.

In addition, a relationship between an arithmetic mean roughness $Ra_{40°}$ on the surface of the glass article 100 at a point where the angle formed between the first chamfered portion 15 and the first main surface 11 is 40°, an arithmetic mean roughness $Ra_{60°}$ on the surface of the glass article at a point where the angle formed between the first chamfered portion and the first main surface is 60°, and an arithmetic mean roughness $Ra_{80°}$ on the surface of the glass article 100 at a point where the angle formed between the first chamfered portion 15 and the first main surface 11 is 80° is preferably $Ra_{40°} < Ra_{60°} < Ra_{80°}$. Within the above range, the surface roughness gradually increases from the region where the angle formed is 40° or less to the region where the angle formed is 80° or more, so that the boundary region is not visually recognized linearly, and the aesthetics can be further improved.

More specifically, the arithmetic mean roughness $Ra_{80°}$ on the surface of the glass article 100 at the point where the angle formed is 80° is preferably 0.25 $\mu$m or more. In the case where the $Ra_{80°}$ is within the above range, scattered light easily enters the eyes of the driver, and the red discoloration is easily prevented.

In the region where the angle formed between the first chamfered portion 15 and the first main surface 11 is greater than 80° and in the side surface portion 14, the average value $Ra_3$ of the arithmetic mean roughness Ra on the surface of the glass article 100 is 0.30 $\mu$m or more and preferably 0.35 $\mu$m or more. Within the above range, the red discoloration of the end portion can be remarkably prevented by the above effects.

The first chamfered portion 15 preferably has a width of 0.5 mm or more and 5.0 mm or less. The width of the first chamfered portion 15 is more preferably 1.0 mm or more, still more preferably 1.3 mm or more, and particularly preferably 1.5 mm or more. Within the above range, the curved surface shape of the end portion is easily visually recognized even in the cover glass of the in-vehicle display device, and design properties are excellent.

Note that, the width of the first chamfered portion 15 is a distance in a direction along the main surface in a cross-sectional view, and for example, a width A in FIG. 4 may be used.

The region where the angle formed between the first chamfered portion 15 and the first main surface 11 is greater than 0° and 40° or less preferably has a width of 0.43 mm or more and 4.8 mm or less. The width is more preferably 0.5 mm or more, and still more preferably 0.75 mm or more, and the upper limit thereof is more preferably 4.0 mm or less, and still more preferably 3.0 mm or less. Within the above range, the chamfered shape of the first chamfered portion 15 is easily visually recognized, and the aesthetics are excellent.

The first chamfered portion 15 has a curved surface shape. The curved surface may have a single radius of curvature, or may have a shape in which curved surfaces having a plurality of radii of curvature are combined. At this time, the radius of curvature at a point where the angle formed between the first chamfered portion 15 and the first main surface is 45° is preferably 0.05 mm or more, and more preferably 0.1 mm or more. Within the above range, the side surface portion 14 and the first chamfered portion 15 are smoothly connected to each other, which helps in improving the aesthetics and preventing chipping. On the other hand, the average radius of curvature of the first chamfered portion 15 is preferably 10 mm or less, more preferably 6 mm or less, and still more preferably 4 mm or less. Within the above range, the first chamfered portion 15 is easily visually recognized as a curved surface, and the aesthetics are excellent. On the other hand, since the thickness of the antireflection layer easily changes in the above range, the red discoloration is likely to occur and thus, the prevention of red discoloration according to the present invention is effective.

As illustrated in FIG. 4, the end surface 13 may further include a second chamfered portion 16 on a second main surface 12 side. Note that, in FIG. 4, the antireflection layer is omitted. The second chamfered portion 16 connects the second main surface 12 and the side surface portion 14. In FIG. 4, the second chamfered portion 16 is a flat surface, but may be a curved surface similar to the first chamfered portion 15.

At this time, the end surface 13 may be designed such that the parameter R represented by the following expression (2) is within a range that satisfies the expression (3). The parameter R preferably falls within a predetermined range since impact resistance of the end surface 13 can be improved and cracking can be prevented.

$$R = 0.38 \cdot E_{cg} \text{-} A/t \text{-} 2.61 \cdot B/t + 4.38 \cdot C/t \text{-} 10.6 \cdot D/t \qquad (2)$$

$$R \leq 23.58 \qquad (3)$$

Here, in the expression (2), $E_{cg}$ represents a Young's modulus (GPa) of the glass article 100, and A represents the width (mm) of the first chamfered portion 15, and is a distance from a boundary position F1 to a boundary position F2 in a direction along a reference line LC. In addition, B in the expression (2) represents a width (mm) of the second chamfered portion 16, and is a distance from a boundary position F3 to a boundary position F4 in the direction along the reference line LC. In addition, C in the expression (2) represents a thickness (mm) of the side surface portion 14, and is a distance from the boundary position F2 to the boundary position F3. In addition, D in the expression (2) represents a thickness (mm) of the first chamfered portion 15, and is a distance from the boundary position F1 to the boundary position F2 in a tangential direction of the outermost position at the end surface 13. In addition, t in the expression (2) represents the thickness (mm) of the glass article 100. Further, in the expression (2), "·" means a product and is also referred to as "×".

In the case where the parameter R satisfies the above expression (3), the impact resistance of the end portion can be improved in the glass article 100. Here, the parameter R decreases as the width A of the first chamfered portion 15 and the width B of the second chamfered portion 16 increase. That is, when the width A of the first chamfered portion 15 is increased, a contact portion of an impactor moves away from the end surface 13, and the impact of the impactor can be absorbed by the first main surface 11, thereby improving an impact property of the end surface 13. When the widths of the first chamfered portion 15 and the second chamfered portion 16 are increased, the thickness of the end surface 13 is smaller with respect to the thickness t of the glass article 100, thereby reducing the bending stress generated on the end surface 13 and improving the impact property of the end surface 13. The parameter R decreases as the thickness D of the first chamfered portion 15 increases. That is, when the thickness of the end surface 13 is smaller with respect to the thickness t of the glass article 100, the bending stress generated on the end surface 13 decreases, and the impact resistance of the end surface 13 can be improved. The parameter R increases as the thickness C of the side surface portion 14 decreases. That is, when the thickness of the side surface portion 14 is reduced, the region of the first chamfered portion 15 is enlarged and the thickness of the end surface 13 is smaller with respect to the thickness t of the glass article 100, thereby decreasing the bending stress generated on the end surface 13 and improving the impact property of the end surface 13.

Here, the positions of the first chamfered portion 15, the second chamfered portion 16, and the side surface portion 14 can be specified by the boundary positions F1, F2, F3, and F4. Specifically, in the end surface 13 of the glass article 100, the region from the boundary position F1 to the boundary position F2 is the first chamfered portion 15, the region from the boundary position F2 to the boundary position F3 is the side surface portion 14, and the region from the boundary position F3 to the boundary position F4 is the second chamfered portion 16.

The boundary positions F1 to F4 can be defined as follows.

In the case where the cross-sectional view of the glass article 100 is observed by using a digital microscope (for example, VHK-6000 manufactured by KEYENCE CORPORATION), that is, the cross section of the glass article 100 is observed from the direction perpendicular to the thickness direction, when the first main surface 11 is a flat surface, the straight line passing through the above positions P2 and P3 is defined as LC, and when the first main surface 11 is a curved surface, an arc line passing through three points, namely the positions P2 and P3, and an arbitrary intermediate point between the position P2 and the position P3, is defined as the reference line LC. In the case where the reference line LC is extended to the outside of the glass article 100 from the position P2, a point on the first main surface 11 where a distance from the extension line of the line LC is 50 $\mu$m and that is closest to the position P2 may be defined as the boundary position F1.

A line perpendicular to the line LC passing through the boundary position F1 is defined as a line LC1. Here, a point where a line parallel to the line LC1 and the end surface 13 meet at one point is defined as the outermost position of the end surface 13 (that is, a position of the end surface 13 that protrudes most outwardly from the glass article 100). In this case, of intersection points between the end surface 13 and a line obtained by moving the line parallel to the line LC1 at the outermost position of the end surface 13 by 50 $\mu$m in a direction perpendicular to the line, the intersection point closer to the first main surface may be defined as the boundary position F2. On the other hand, of the intersection points between the end surface 13 and the line obtained by moving a line parallel to the line LA1 at the outermost position of the end surface 13 by 50 $\mu$m in the direction perpendicular to the line, the intersection point closer to the second main surface may be defined as the boundary position F3.

A line obtained by moving the line LC by the thickness t of the glass article 100 in the thickness direction of the glass article 100 is defined as a line LD. The line LD may be regarded as a line along the second main surface 12. In the case where the line LD is extended to the end surface 13 side, the innermost point on the second main surface 12 where a distance from the extension line of the line LD is 50 $\mu$m may be defined as the boundary position F4.

From the viewpoint of improving the impact resistance of the end portion, the width A of the first chamfered portion 15 is preferably 2.0 mm or less, and more preferably 0.5 mm or more and 2.0 mm or less. In addition, the glass article thickness ratio (A/t), which is a ratio of the width A of the first chamfered portion 15 to the thickness t of the glass article 100, is preferably 0.77 or more, and more preferably 1.15 or more. In the case where the width A is within this range, the impact property of the end surface 13 can be more suitably improved.

The width B of the second chamfered portion 16 is preferably greater than 0 mm and 2.0 mm or less, and more preferably 1.0 mm or more and 2.0 mm or less. In addition, the glass article thickness ratio (B/t), which is a ratio of the width B of the second chamfered portion 16 to the thickness t of the glass article 100, is preferably 0.77 or more and 4.0 or less, and more preferably 1.15 or more and 2.86 or less. In the case where the width B is within this range, the impact property of the end surface 13 can be more suitably improved.

The thickness C of the side surface portion 14 is preferably equal to or smaller than the thickness t of the glass article 100, more preferably greater than 0 mm and 2.0 mm or less, and still more preferably 0.25 mm or more and 2.0 mm or less. In addition, the glass article thickness ratio (C/t), which is a ratio of the thickness C of the side surface portion 14 to the thickness t of the glass article 100, is preferably 0.6 or less, and more preferably 0.4 or less. In the case where the thickness C is within this range, the impact property of the end surface 13 can be more suitably improved.

The thickness D of the first chamfered portion 15 is preferably greater than 0 mm and equal to or smaller than the thickness t of the glass article 100, more preferably greater than 0 mm and 2.0 mm or less, and still more preferably 0.1 mm or more and 2.0 mm or less. In addition, the glass article thickness ratio (D/t), which is a ratio of the thickness D of the first chamfered portion 15 to the thickness t of the glass article 100, is preferably 0.2 or more, and more preferably 0.4 or more, and the upper limit is preferably 0.7 or less. That is, the ratio (D/t) is preferably 0.2 or more and 0.7 or less. In the case where the thickness D is within this range, the impact property of the end surface 13 can be more suitably improved.

That is, examples of a preferred embodiment of the chamfered portion include the followings.

(i) The width A of the first chamfered portion 15 is 2.0 mm or less and satisfies the glass article thickness ratio (A/t) of 0.77 or more, the width B of the second chamfered portion 16 satisfies the glass article thickness ratio (B/t) of 0.77 or more and 4.0 or less, the thickness C of the side surface portion 14 is 0.25 mm or more and satisfies the glass article thickness ratio (C/t) of 0.6 or less, and the thickness D of the first chamfered portion 15 satisfies the glass article thickness ratio (D/t) of 0.2 or more and 0.7 or less.

(ii) The width A of the first chamfered portion 15 is 2.0 mm or less and satisfies the glass article thickness ratio (A/t) of 1.15 or more, the width B of the second chamfered portion 16 satisfies the glass article thickness ratio (B/t) of 1.15 or more and 2.86 or less, the thickness C of the side surface portion 14 is 0.25 mm or more and satisfies the glass article thickness ratio (C/t) of 0.4 or less, and the thickness D of the first chamfered portion 15 satisfies the glass article thickness ratio (D/t) of 0.4 or more and 0.7 or less.

(iii) The width A of the first chamfered portion 15 is 2.0 mm or less and satisfies the glass article thickness ratio (A/t) of 0.77 or more, the width B of the second chamfered portion 16 is 1.0 mm or more and 2.0 mm or less, the thickness C of the side surface portion 14 is 0.25 mm or more and satisfies the glass article thickness ratio (C/t) of 0.6 or less, and the thickness D of the first chamfered portion 15 satisfies the glass article thickness ratio (D/t) of 0.2 or more and 0.7 or less.

(iv) The width A of the first chamfered portion 15 is 2.0 mm or less and satisfies the glass article thickness ratio (A/t) of 1.15 or more, the width B of the second chamfered portion 16 is 1.0 mm or more and 2.0 mm or less, the thickness C of the side surface portion 14 is 0.25 mm or more and satisfies the glass article thickness ratio (C/t) of 0.4 or less, and the thickness D of the first chamfered portion 15 satisfies the glass article thickness ratio (D/t) of 0.4 or more and 0.7 or less. Further, the second chamfered portion 16 has a C-chamfered shape.

(Color Tone of Reflected Light)

The reflected light on the first main surface is preferably white from the viewpoint of correctly recognizing a color of an image displayed on the display device. However, for example, in the method in Patent Literature 1, by adjusting the design of the antireflection layer 20 such that a reflected color on the first main surface 11 is made to appear closer to blue, even if the end portion appears relatively reddish, the end portion is perceived as white, thereby preventing red discoloration. Therefore, it is difficult to prevent the red discoloration of the end portion while keeping the first main surface 11 white. However, with the glass article according to the present embodiment, it is possible to prevent the red discoloration of the end portion while making the first main surface 11 white.

The color tone of the reflected light from the first main surface 11 is preferably $-3 < a^* < 3$ and $-3 < b^* < 3$, and more preferably $-2.5 < a^* < 2.5$ and $-2.5 < b^* < 2.5$ in an $L^*a^*b^*$ color system. Within the above range, the color tone of the reflected light is sufficiently recognized as white. Here, the color tone of the reflected light on the first main surface 11 may be measured in an SCI mode of a spectrophotometer (for example, CM-2600D manufactured by Konica Minolta, Inc.).

On the other hand, regarding the color tone of the reflected light in the $L^*a^*b^*$ color system at each measurement point of the first chamfered portion 15, which is measured by using the following measurement method, an average value of $a^*$ at the measurement points that satisfy $L^* \geq 5$ is preferably 0 or more and 15.0 or less.

(Measurement Method)

In the first chamfered portion 15, a perpendicular line at a point where the angle formed between the first chamfered portion 15 and the first main surface 11 is 45° is used as a reference, white light is incident on a side surface portion 14 side at an angle of 10°, and an spectroscopic image is obtained by using a two-dimensional spectroradiometer (for example, "SR-5000" manufactured by TOPCON TECHNOHOUSE CORPORATION) at an angle of 10° toward a first main surface 11 side.

In the obtained image, the measurement point is defined by segmenting the image for each pixel, and the color tone at each measurement point is calculated in the $L^*a^*b^*$ color system. Note that, the calculation of the $L^*a^*b^*$ color system conforms to JIS Z 8781-4.

The present inventors have found that at points that satisfy $L^* \geq 5$, red is particularly likely to be strongly recognized due to high lightness, and that preferentially reducing $a^*$ at the points satisfying $L^* \geq 5$ is effective from the viewpoint of making red less noticeable. As a result of experiments, it has been found that when the average value of $a^*$ at the measurement points that satisfy $L^* \geq 5$ is 0 or more and 15.0 or less, the redness viewed by the viewer can be significantly reduced.

Further, it is more effective when the average value of $a^*$ at the measurement points that satisfy $L^* \geq 5$ is more preferably 10.0 or less, still more preferably 8.0 or less, and particularly preferably 6.0 or less.

(Glass)

As the glass 10, an alkali-free glass, a soda lime glass, a soda lime silicate glass, an aluminosilicate glass, a borosilicate glass, a lithium aluminosilicate glass, a borosilicate glass, or the like can be used. An aluminosilicate glass and a lithium aluminosilicate glass are preferred since they can easily undergo a large stress by a strengthening treatment and can provide a high-strength glass even with a small thickness.

The glass 10 is preferably, for example, a chemically strengthened glass strengthened by a chemical strengthening treatment.

Examples of a method for subjecting the glass 10 to a chemical strengthening treatment to obtain a chemically strengthened glass include, typically, a method of immersing a glass in a $KNO_3$ molten salt to conduct an ion exchange treatment, followed by cooling the glass to around room temperature. Treatment conditions such as a temperature of the $KNO_3$ molten salt and an immersion time may be set such that a surface compressive stress and a thickness of a compressive stress layer have desired values.

The surface compressive stress (CS) of the compressive stress layer is preferably 500 MPa or more, more preferably 600 MPa or more, and still more preferably 700 MPa or more. On the other hand, the CS is preferably 1300 MPa or less. That is, the surface compressive stress (CS) of the compressive stress layer is preferably in the range of 500 MPa or more and 1300 MPa or less.

The thickness (DOL) of the compressive stress layer is preferably 10 $\mu$m or more, more preferably 15 $\mu$m or more, still more preferably 20 $\mu$m or more, and particularly preferably 25 $\mu$m or more. In addition, the DOL is preferably 50 $\mu$m or less, and more preferably 40 $\mu$m or less. That is, the thickness (DOL) of the compressive stress layer is preferably in the range of 10 $\mu$m or more and 50 $\mu$m or less.

In the case of performing chemical strengthening, examples of a glass type include a soda lime glass and an aluminosilicate glass ($SiO_2$-$Al_2O_3$-$Na_2O$-based glass). Among them, an aluminosilicate glass is preferred from the viewpoint of strength.

Examples of a glass material include a glass material containing, in mol% in terms of oxides, 50% or more and 80% or less of $SiO_2$, 1% or more and 20% or less of $Al_2O_3$, 6% or more and 20% or less of $Na_2O$, 0% or more and 11% or less of $K_2O$, 0% or more and 15% or less of MgO, 0% or more and 6% or less of CaO, and 0% or more and 5% or less of $ZrO_2$.

A glass for chemical strengthening based on an aluminosilicate glass is also suitably used, and examples thereof include "Dragontrail (registered trademark)" manufactured by AGC Inc.

More specifically, a more preferred composition of the glass includes the followings. Note that, for example, "containing 0% to 25% of MgO" means that MgO is not essential but may be contained up to 25%. The glass in (i) below is categorized as a soda lime silicate glass, the glasses in (ii) and (iii) below are categorized as an aluminosilicate glass, and the glasses in (iv) to (vi) below are categorized as a lithium aluminosilicate glass.

(i) A glass having a composition containing, in mol% in terms of oxides, 63% to 73% of $SiO_2$, 0.1% to 5.2% of $Al_2O_3$, 10% to 16% of $Na_2O$, 0% to 1.5% of $K_2O$, 0% to 5.0% of $Li_2O$, 5% to 18% of MgO, and 1% to 10% of CaO.

(ii) A glass having a composition containing, in mol% in terms of oxides, 50% to 74% of $SiO_2$, 5% to 15% of $Al_2O_3$, 10% to 20% of $Na_2O$, 0% to 8% of $K_2O$, 0% to 5.0% of $Li_2O$, 2% to 15% of MgO, 0% to 6% of CaO, and 0% to 5% of $ZrO_2$, in which a total content of $SiO_2$ and $Al_2O_3$ is 65% to 85%, a total content of $Na_2O$ and $K_2O$ is 12% to 25%, and a total content of MgO and CaO is 1% to 15%.

(iii) A glass having a composition containing, in mol% in terms of oxides, 68% to 80% of $SiO_2$, 4% to 10% of $Al_2O_3$, 5% to 15% of $Na_2O$, 0% to 1% of $K_2O$, 0% to 5.0% of $Li_2O$, 4% to 15% of MgO, and 0% to 1% of $ZrO_2$.

(iv) A glass having a composition containing, in mol% in terms of oxides, 67% to 75% of $SiO_2$, 0% to 4% of $Al_2O_3$, 7% to 15% of $Na_2O$, 1% to 9% of $K_2O$, 0% to 5.0% of $Li_2O$, 6% to 14% of MgO, and 0% to 1.5% of $ZrO_2$, in which a total content of $SiO_2$ and $Al_2O_3$ is 71% to 75%, a total content of $Na_2O$ and $K_2O$ is 12% to 20%, and a content of CaO is less than 1% in the case where CaO is contained.

(v) A glass having a composition containing, in mol% in terms of oxides, 50% to 73% of $SiO_2$, 5% to 20% of $Al_2O_3$, 0% to 6% of $B_2O_3$, 0% to 10% of $P_2O_5$, 4% to 12% of $Li_2O$, 3% to 20% of $Na_2O$, 0% to 5% of $K_2O$, 0% to 8% of MgO, 0% to 2% of CaO, 0% to 5% of SrO, 0% to 5% of BaO, 0% to 5% of ZnO, 0% to 2% of $TiO_2$, and 0% to 4% of $ZrO_2$.

(vi) A glass having a composition containing, in mol% in terms of oxides, 58% to 80% of $SiO_2$, 13% to 18% of $Al_2O_3$, 0% to 5% of $B_2O_3$, 0.5% to 4% of $P_2O_5$, 3% to 10% of $Li_2O$, 5% to 20% of $Na_2O$, 0% to 2% of $K_2O$, 0% to 11% of MgO, 0% to 20% of CaO, 0% to 20% of SrO, 0% to 15% of BaO, 0% to 10% of ZnO, 0% to 1% of $TiO_2$, and 0% to 2% of $ZrO_2$.

The thickness of the glass is not particularly limited, and is preferably 5 mm or less, and more preferably 3 mm or less in order to effectively perform the chemical strengthening treatment. In the case where the glass is used as a cover glass of an in-vehicle display device for car navigation or the like, the thickness of the glass is preferably 0.2 mm or more, more preferably 0.8 mm or more, and still more preferably 1 mm or more from the viewpoint of strength. Note that, the thickness of the glass refers to a distance in a normal direction between a first main surface 10A and a second main surface 10B of the glass 10. That is, the thickness of the glass is preferably in the range of 0.2 mm or more and 5 mm or less.

The dimension of the glass 10 can be appropriately selected according to the application. In the case of being used as a cover material of an in-vehicle display device, the length of a short side is, for example, 50 mm or more and 500 mm or less, and preferably 100 mm or more and 300 mm or less, and the length of a long side is, for example, 50 mm or more and 1500 mm or less, and preferably 100 mm or more and 1200 mm or less.

The shape of the glass 10 may be a flat shape, or may be a shape having a three-dimensional curved surface having one or more curved portions or bent portions.

Here, the curved surface in the present embodiment means that the radius of curvature is 10000 mm or less, whereas the flat surface means that the radius of curvature is more than 10000 mm.

In the case where the glass 10 has a curved surface, the radius of curvature of the curved surface is preferably 50 mm or more, more preferably 100 mm or more, and still more preferably 200 mm or more. The radius of curvature is, for example, 10000 mm or less, preferably 5000 mm or less, and more preferably 3000 mm or less.

Here, the Young's modulus ($E_{cg}$) of the glass 10 is preferably 60 GPa or more, and more preferably 70 GPa or more. The Young's modulus ($E_{cg}$) of the glass article 100 is preferably 90 GPa or less, more preferably 80 GPa or less, and still more preferably 75 GPa or less. That is, the Young's modulus of the glass 10 is preferably 60 GPa or more and 90 GPa or less, more preferably 70 GPa or more and 80 GPa or less, and still more preferably 70 GPa or more and 75 GPa or less. The Young's modulus of the glass 10 may be determined by a tensile test (JIS K7161, JIS K7113).

(Antireflection Layer)

The antireflection layer 20 is formed on the first main surface 11 side of the glass article 100. In FIG. 2, the antireflection layer 20 is formed on the surface of the glass 10.

The antireflection layer is a layer that can provide an effect of reducing a luminous reflectance, can reduce glare caused by reflected light, and in the case where the glass article 100 is used in an image display device, can improve a transmittance of light from the image display device, and can improve visibility of the image display device.

The antireflection layer 20 is made of, for example, a metal oxide. The antireflection layer 20 may have any configuration as long as it can prevent reflection of light. For example, it is possible to have a configuration in which a high refractive index layer having a refractive index of 1.9 or more at a wavelength of 550 nm and a low refractive index layer having a refractive index of 1.6 or less at a wavelength of 550 nm are alternately laminated. The number of the low refractive index layer and the high refractive index layer is not particularly limited, and is, for example, 1 or more and 30 or less. The number of the low refractive index layers is preferably 1 or more and 6 or less, and the number of the high refractive index layers is preferably the same as the number of the low refractive index layers.

In the case where the antireflection layer 20 is composed of a plurality of low refractive index layers and a plurality of high refractive index layers, for example, composed of 6 layers, when the layer farthest from the glass 10 is the outermost layer and the number of the layers is counted from the outermost layer, as the first layer, to a glass substrate side, odd-numbered layers including the outermost layer, that is, the outermost layer, the third layer, and the fifth layer, are low refractive index layers. When the layer adjacent to the glass substrate side from the outermost layer is the second layer, even-numbered layers including the second layer, that is, the second layer, the fourth layer, and the sixth layer, are high refractive index layers. The sixth layer, which is the high refractive index layer farthest from the outermost layer, is in contact with the glass 10.

In the case of being composed of one low refractive index layer and one high refractive index layer, the low refractive index layer is the outermost layer and the high refractive index layer is the second layer.

The low refractive index layer is made of a material containing silicon, for example. For example, it may be silicon oxide, aluminum-doped silicon oxide in which silicon oxide is doped with aluminum, or a material in which tin or zirconia is added to silicon oxide.

A main component of the high refractive index layer constituting the second layer is preferably one or more selected from, for example, silicon nitride, titanium oxide, niobium oxide, tantalum oxide, and zirconium oxide. Further, among these materials, from the viewpoint of productivity and the refractive index, silicon nitride, niobium oxide, and tantalum oxide are more preferred, and niobium oxide is most preferred.

Main components of the even-numbered layers of the fourth layer and thereafter, for example, main components of the fourth layer and the sixth layer, may be made of a material same as that of the second layer, or made of a material different from that of the second layer. In the case where the main component constituting the second layer is niobium oxide, the even-numbered layers of the fourth layer and thereafter may be made of niobium oxide same as the second layer, or may be made of a different material from that of the second layer.

Note that, the antireflection layer 20 may have a different total number of high refractive index layers and low refractive index layers, and in the case where the total numbers are different, for example, the outermost layer and the layer in contact with the glass are preferably low refractive index layers, and the main component of the low refractive index layer in contact with the glass is preferably silicon oxide.

The total thickness of the antireflection layer 20 is, for example, 100 nm or more and 1000 nm or less, preferably 150 nm or more and 550 nm or less, more preferably 190 nm or more and 510 nm or less, and most preferably 195 nm or more and 506 nm or less.

The thickness of the outermost layer is, for example, 60 nm or more and 130 nm or less, preferably 70 nm or more and 100 nm or less, more preferably 75 nm or more and 90 nm or less, and still more preferably 77 nm or more and 88 nm or less.

The thickness of the second layer is, for example, 15 nm or more and 200 nm or less, preferably 20 nm or more and 150 nm or less, and more preferably 25 nm or more and 115 nm or less.

Note that, the thickness of the antireflection layer 20 is measured on the first main surface 11. Examples of measurement for the thickness include measurement of an actual thickness by cross-sectional observation using SEM (scanning electron microscopy) or TEM (transmission electron microscopy), or optical measurements using a polarization analysis method. In the case of applying an antiglare treatment, it is preferable to measure the actual thickness by using a SEM or a TEM. In addition, in the case where the refractive index of each layer is known, the thickness can be derived from a spectral reflectance or a transmittance (Reference: "Academic Thin Films and Film Forming Technology" Author: Lee Jeong-jung, Translator: ULVAC, Publisher: AGNE Technology Center, Publication year: 2002). In particular, in the case where the refractive index of each layer is known, it is preferable to measure the thickness by using the spectral reflectance.

(Other Decorative Layers)

Although not illustrated, a decorative layer such as an antiglare layer or an antifouling layer may be provided on the first main surface 11 side of the glass article 100. The following antiglare layer and antifouling layer are examples, and may be appropriately changed within a range including the function of each layer. In addition, the antiglare layer and the antifouling layer are not essential configurations, and may not be partially provided according to the configuration of the glass article 100.

The antiglare layer is provided on the first main surface 11 side and imparts antiglare properties to the glass 10. The antiglare layer has, for example, an uneven shape formed on the first main surface 11 side. The uneven shape may be formed by directly forming unevenness on the surface of the glass 10, or may be formed by another layer different from the glass 10. In addition, it may be provided on both the first main surface 11 side and the second main surface 12 side. The root mean square roughness (RMS) of the uneven shape is preferably 10 nm to 1000 nm, and more preferably 15 nm to 500 nm. The antiglare layer can be implemented by an uneven shape imparted by subjecting the surface of the glass 10 to an antiglare treatment and an etching treatment. In addition, a coating film in which particles having an arbitrary refractive index are dispersed may be used on the surface of the glass 10, or an uneven shape may be formed on a main surface of a transparent resin film to be attached, to implement the uneven shape.

The antifouling layer is an antifouling layer having a function of preventing adhesion of various stains such as fingerprint marks, sweat, and dust to make stains less noticeable or a function of making it easy to clean adhered stains, and keeps a display surface clean. The antifouling layer is provided on the first main surface 11 side, and is preferably formed on the outermost surface on the first main surface 11 side of the glass article 100 from the viewpoint of properties of the antifouling layer. For example, the antifouling layer is provided on the antireflection layer. The antifouling layer is made of a fluorine-containing compound (a compound having a fluorine-containing organic group) capable of imparting antifouling properties, water repellency, and oil repellency. The fluorine-containing compound is preferably a fluorine-containing organic compound, and more preferably a fluorine-containing organosilicon compound.

(Printed Layer)

Although not illustrated, a printed layer may be provided on the second main surface side of the glass article 100. The printed layer is provided, for example, on an outer peripheral portion of the glass article 100, has an opening, and plays a role of hiding a wiring member or the like disposed on a peripheral edge portion of the display panel 3 so as not to be visually recognized by the driver. The opening is used as a display region when the display panel 3 is turned on. The number of openings may be one, or may be two or more. The printed layer is not particularly limited as long as visible light can be shielded, and is, for example, a black or wood grain pattern.

The glass article 100 provided with the printed layer on the second main surface side can be used as a display cover glass.

<Method for Producing Glass Article>

Next, a method for producing a glass article according to the present embodiment is described.

(Preparation of Glass)

The glass 10 having the first main surface 11 and the second main surface 12 is prepared. The method for producing the glass 10 is not particularly limited, and the glass 10 can be produced, for example, by charging desired glass raw materials into a melting furnace, followed by heating and melting at 1500°C to 1600°C and refining, and then supplying the molten glass to a shaping apparatus to shape the molten glass into a flat plate shape, followed by gradually cooling. Note that, a method for shaping the glass is not particularly limited, and for example, a down-draw method (for example, an overflow down-draw method, a slot-down method, and a re-draw method), a float method, a roll-out method, and a pressing method can be used.

The production method may also include a shaping step of cutting the flat glass obtained as described above into a desired shape and size, and curving the glass into a three-dimensional shape while heating the glass. By such a shaping step, a curved surface is formed on the glass 10.

(Chamfered Portion Forming Step)

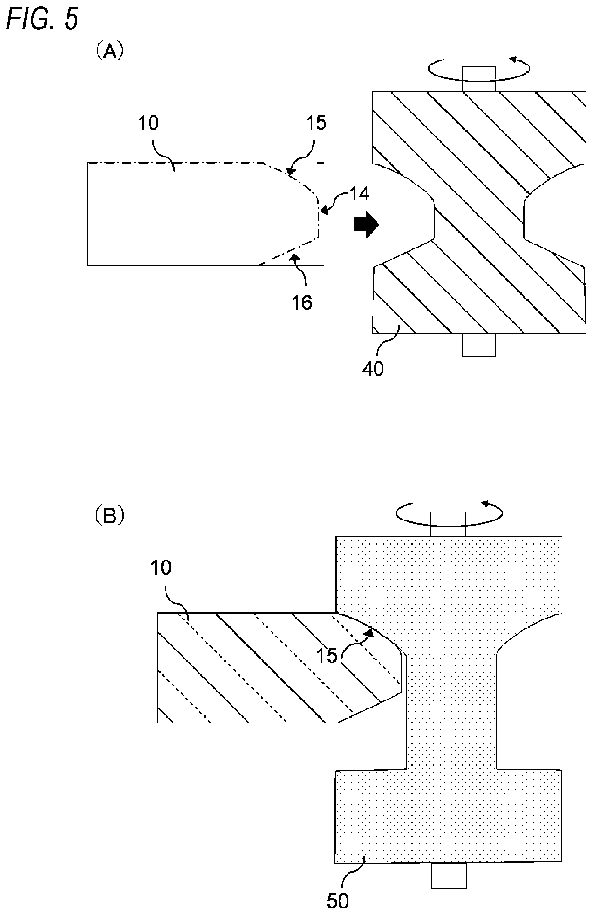

First, the end surface 13 of the obtained glass is ground to form a curved surface shape of the first chamfered portion 15. (A) of FIG. 5 schematically illustrate a state in which the first chamfered portion 15 is formed by grinding. Note that, in (A) of FIG. 5, hatching of the glass 10 is omitted for the sake of explanation. As illustrated in (A) of FIG. 5, when the end surface 13 of the glass 10 is pressed against a rotary grindstone 40, the end surface 13 is ground to form the side surface portion 14, the first chamfered portion 15, and the second chamfered portion 16 as indicated by broken lines. For the grinding, for example, an electrodeposited wheel (for example, #325 or more) can be used. The grinding may be performed over the entire circumference of the glass 10 or may be performed in a partial section of the circumference. The surface roughness of the end surface 13 chamfered by the above method may be, for example, 0.2 μm to 1.0 μm in terms of an arithmetic mean roughness Ra. Note that, the method of forming the chamfered portion is not limited to the above, and the chamfered portion may be formed by laser cutting or the like.

(Polishing Step)

Next, the first chamfered portion 15 is polished to reduce the surface roughness.

Here, a polishing method in the related art is described. In the related art, a nonwoven fabric brush or a carpet pad has been used for polishing a chamfered portion (for example, WO 2015/108076 and WO 2013/031548). According to the method in the related art, since the entire end surface 13 including the first chamfered portion 15 and partial regions of the first main surface 11 and the second main surface 12 are polished, the surface roughness of the entire end surface 13 is reduced.

On the other hand, in the production method according to the present embodiment, the first chamfered portion 15 is polished by using a rotary grindstone 50 as illustrated in (B) of FIG. 5. For example, a grindstone including cerium oxide can be used as the rotary grindstone 50. In (B) of FIG. 5, a groove is provided in the rotary grindstone 50, and a lower portion of the groove has a shape along a curved surface of the first chamfered portion 15. The surface of the first chamfered portion 15 is polished by pressing the first chamfered portion 15 against the portion.

At this time, it is preferable that positions of the glass 10 and the rotary grindstone 50 are adjusted such that a region where the angle formed between the first chamfered portion 15 and the first main surface 11 is greater than 0° and 40° or less is polished intensively. On the other hand, it is preferable that the region where the angle formed between the first chamfered portion 15 and the first main surface 11 is greater than 80° and the side surface portion 14 are not brought into intensive contact with the rotary grindstone 50. In addition, it is preferable that the pressing position, the pressing pressure, and the like are appropriately adjusted for polishing such that the roughness gradually increases from the region where the angle formed is 40° or less to the region where the angle formed is greater than 80°.

As described above, each region is polished so as to have the surface roughness described in the above <Glass Article>.

(Chemical Strengthening Step)

In the case where the glass article 100 is used as a cover glass of a display device, it is preferable to chemically strengthen the obtained glass 10. The chemical strengthening treatment method is not particularly limited, and examples thereof include a method of subjecting a main surface of a transparent substrate to ion exchange to form a surface layer in which a compressive stress remains. Specifically, at a temperature equal to or lower than the glass transition point, alkali metal ions having a small ionic radius (for example, Li ions or Na ions) contained in the glass near the main surface of the substrate are substituted with alkali metal ions having a larger ionic radius (for example, Na ions or K ions for Li ions, and K ions for Na ions). Accordingly, the compressive stress remains on the main surface of the transparent substrate 10, and the strength of the transparent substrate is improved.

(Printed Layer Forming Step)

In the case where the glass article 100 is used as a cover glass of a display device, it is preferable to form a printed layer on the second main surface 12 side of the obtained glass 10. The printed layer is formed by using, for example, a method of printing an ink, and is preferably formed by printing on an outer peripheral portion of the second main surface 12 with a design having an opening. The printing method is not particularly limited, and preferred examples thereof include an ink jet method, a screen-printing method, and a transfer decoration method.

(Antireflection Layer Forming Step)

The antireflection layer 20 is formed on the first main surface 11 side of the obtained glass 10. The antireflection layer preferably has a laminated structure of a metal oxide layer as described in the above (Antireflection Layer). The film-forming method for the metal oxide layer is not particularly limited, and various film-forming methods can be used. For example, physical vapor deposition methods such as a vacuum deposition method, an ion beam-assisted deposition method, an ion plate method, a sputtering method, or a plasma CVD method can be used. Among these film-forming methods, use of a sputtering method is preferred since a dense and highly durable film can be formed. Particularly, it is preferable to form the film by a sputtering method such as a pulse-sputtering method, an AC-sputtering method, and a digital-sputtering method.

In the case where the metal oxide layer is formed by using a sputtering method, the glass 10 is disposed in a chamber of a mixed gas atmosphere containing an inert gas and an oxygen gas, a target of a raw material having a desired composition is selected for each layer, and a film is formed. The layer thickness of each layer can be adjusted by, for example, adjusting discharge power, adjusting a film-forming time, or the like.

(Other Decorative Layer Forming Step)

In addition, a decorative layer such as an antiglare layer or an antifouling layer may be formed on the first main surface 11 side of the glass 10 or on the first main surface 11 side and the second main surface 12 side of the glass 10. The antiglare layer, the antireflection layer, and the antifouling layer are appropriately formed by using a known method. The order of forming the antiglare layer, the antireflection layer, and the antifouling layer is not particularly limited. It is preferable that the antiglare layer is formed after the chemical strengthening step, and the antifouling layer is formed after the antireflection layer is formed.

Through the above steps, the glass article 100 can be produced.

(Method for Producing In-vehicle Display Device)

The present invention also provides a display device (specifically, an in-vehicle display device) including a display cover glass using the glass article 100 and a display in which the second main surface side of the glass article 100 is attached to the display.

The display device (in-vehicle display device) can be produced by using the glass article 100 as a display cover glass and attaching the second main surface 12 side to the display panel 3.

The present disclosure describes the following invention. Note that, the present invention is not limited thereto.

[1] A glass article including:

a first main surface;
a second main surface; and
an end surface connecting the first main surface and the second main surface, in which
the end surface includes a side surface portion and a first chamfered portion having a curved surface shape connecting the side surface portion and the first main surface,
the first main surface and the first chamfered portion include an antireflection layer,
in a region where an angle formed between the first chamfered portion and the first main surface is greater than 0° and 40° or less, an average value $Ra_1$ of an arithmetic mean roughness Ra on a surface of the glass article is 0.20 $\mu$m or less,
in a region where the angle formed between the first chamfered portion and the first main surface is greater than 80° and in the side surface portion, an average value $Ra_3$ of the arithmetic mean roughness Ra on the surface of the glass article is 0.30 $\mu$m or more, and

in a region where the angle formed between the first chamfered portion and the first main surface is 60° or more and 80° or less, an average value $Ra_2$ of the arithmetic mean roughness Ra on the surface of the glass article satisfies the following expression (1).

$$0.2 \leq (Ra_2 - Ra_1)/(Ra_3 - Ra_1) \leq 0.8 \qquad (1)$$

[2] The glass article according to [1], in which the first chamfered portion has a width of 0.5 mm or more and 5.0 mm or less.

[3] The glass article according to [1] or [2], in which the region where the angle formed between the first chamfered portion and the first main surface is greater than 0° and 40° or less has a width of 0.43 mm or more and 4.8 mm or less.

[4] The glass article according to any one of [1] to [3], in which a relationship between an arithmetic mean roughness $Ra_{40°}$ on the surface of the glass article at a point where the angle formed between the first chamfered portion and the first main surface is 40°, an arithmetic mean roughness $Ra_{60°}$ on the surface of the glass article at a point where the angle formed between the first chamfered portion and the first main surface is 60°, and an arithmetic mean roughness $Ra_{80°}$ on the surface of the glass article at a point where the angle formed between the first chamfered portion and the first main surface is 80° is $Ra_{40°} < Ra_{60°} < Ra_{80°}$.

[5] The glass article according to any one of [1] to [4], in which regarding a color tone of reflected light in an L*a*b* color system at each measurement point of the first chamfered portion, which is measured by using the following measurement method, an average value of a* at the measurement points that satisfy $L^* \geq 5$ is 0 or more and 15.0 or less, (measurement method)

in the first chamfered portion, a perpendicular line at a point where the angle formed between the first chamfered portion and the first main surface is 45° is used as a reference, white light is incident on a side surface portion side at an angle of 10°, and an image is obtained by using a two-dimensional spectroradiometer at an angle of 10° toward a first main surface side, and in the image, the measurement point is defined by segmenting the image for each pixel, and the color tone at each measurement point is calculated in the L*a*b* color system.

[6] The glass article according to any one of [1] to [5], in which the color tone of the reflected light from the first main surface satisfies -3 < a* < 3 and -3 < b* < 3 in the L*a*b* color system.

[7] The glass article according to any one of [1] to [6], in which

the end surface includes the side surface portion and a second chamfered portion connecting the side surface portion and the second main surface, and
a parameter R defined by the following expression (2) satisfies the following expression (3):

$$R = 0.38 \cdot E_{cg} - A/t - 2.61 \cdot B/t + 4.38 \cdot C/t - 10.6 \cdot D/t \qquad (2)$$

$$R \leq 23.58 \qquad (3)$$

in the expression (2), $E_{cg}$ represents a Young's modulus (GPa) of the glass article, A represents a width (mm) of the first chamfered portion, B represents a width (mm) of the second chamfered portion, C represents a thickness (mm) of the side surface portion, D represents a thickness (mm) of the first chamfered portion, and t represents a thickness (mm) of the glass article.

[8] The glass article according to [7], in which

the width A of the first chamfered portion is 2.0 mm or less,
a glass article thickness ratio (A/t), which is a ratio of the width A of the first chamfered portion to the thickness of the glass article, is 0.77 or more,
the width B of the second chamfered portion is 1.0 mm or more and 2.0 mm or less,
the thickness C of the side surface portion is 0.25 mm or more,
a glass article thickness ratio (C/t), which is a ratio of the thickness C of the side surface portion to the thickness of the glass article, is 0.6 or less, and
a glass article thickness ratio (D/t), which is a ratio of the thickness D of the first chamfered portion to the thickness of the glass article, is 0.2 or more and 0.7 or less.

[9] The glass article according to any one of [1] to [8], in which the antireflection layer includes a metal oxide film, and is formed by alternately laminating a high refractive index layer having a refractive index of 1.9 or more at a wavelength of 550 nm and a low refractive index layer having a refractive index of 1.6 or less at a wavelength of 550 nm.

[10] The glass article according to [9], in which the number of the low refractive index layer is one or more and six or less.

[11] The glass article according to any one of [1] to [10], in which in the region where the angle formed between the first chamfered portion and the first main surface is greater than 0° and 40° or less, the average value $Ra_1$ of the arithmetic mean roughness Ra on the surface of the glass article is 0.15 $\mu$m or less.

[12] The glass article according to any one of [1] to [11], in which in the region where the angle formed between the first chamfered portion and the first main surface is greater than 0° and 40° or less, the average value $Ra_1$ of the arithmetic mean roughness Ra on the surface of the glass article is 0.10 $\mu$m or less.

[13] The glass article according to any one of [1] to [12], in which in the region where the angle formed between the first chamfered portion and the first main surface is greater than 80° and in the side surface portion, the average value $Ra_3$ of the arithmetic mean roughness Ra on the surface of the glass article is 0.35 $\mu$m or more.

[14] A display cover glass including:

 the glass article according to any one of [1] to [13]; and
 a printed layer on a second main surface side.

[15] The display cover glass according to [14], further including:
an antiglare layer on a first main surface side.

[16] The display cover glass according to claim [14] or [15], further including:
an antifouling layer on or above the antireflection layer.

[17] A display device including:

 the display cover glass according to any one of [14] to [16]; and
 a display, in which
 the second main surface side is attached to the display.

[18] An in-vehicle display device including:

 the display cover glass according to any one of [14] to [16]; and
 a display, in which
 the second main surface side is attached to the display.

[19] A glass article a including:

 a first main surface;
 a second main surface; and
 an end surface connecting the first main surface and the second main surface, in which
 the end surface includes a side surface portion and a first chamfered portion having a curved surface shape connecting the side surface portion and the first main surface,
 the first main surface and the first chamfered portion include an antireflection layer,
 in a region where an angle formed between the first chamfered portion and the first main surface is greater than 0° and 40° or less, an average value of an arithmetic mean roughness Ra on a surface of the glass article is 0.10 $\mu$m or less,
 in a region where the angle formed between the first chamfered portion and the first main surface is greater than 40° and 80° or less, an average value of the arithmetic mean roughness Ra on the surface of the glass article is greater than 0.10 $\mu$m and smaller than 0.35 $\mu$m, and
 in a region where the angle formed between the first chamfered portion and the first main surface is greater than 80° and in the side surface portion, an average value of the arithmetic mean roughness Ra on the surface of the glass article is 0.35 $\mu$m or more.

Examples

Next, Examples are described. Examples 1, 2, 5, and 6 are Inventive Examples, and Examples 3, 4, and 7 are Comparative Examples.

(Examples 1 and 2)

In Examples 1 and 2, as the glass 10, Dragontrail manufactured by AGC Inc. was used to prepare a glass having a substantially rectangular main surface shape with short sides of 50 mm, long sides of 150 mm, and a thickness t of 1.3 mm. The glass 10 had a flat shape having the first main surface 11 and the second main surface 12, and had a Young's modulus of 74 GPa.

The end surface 13 of the glass 10 was ground by the method illustrated in (A) of FIG. 5 to form the side surface portion 14, the first chamfered portion 15, and the second chamfered portion 16. For the grinding, diamond electrodeposited wheels #400 and #800 were used. At this time, in the curved surface shape of the first chamfered portion 15, the radius of curvature at an angle formed of 9° to 19° with the first main surface was 5.5 mm, and the radius of curvature at an angle formed of 45° was 0.4 mm. The first chamfered portion 15 had a width A of 1.67 mm and a thickness D of 0.69, the second chamfered portion 16 had a width B of 0.15 mm, and the side surface portion 14 had a thickness C of 0.46 mm. That is, the parameter R represented by the above expression (1) was 22.45. The width of the region where the angle formed between the first chamfered portion 15 and the first main surface 11 was greater than 0° and 40° or less was 1.96 mm.

Next, the end surface 13 was polished by the method illustrated in (B) of FIG. 5. For the polishing, a grindstone containing cerium oxide was used.

Finally, the antireflection layer 20 was formed on the surface of the glass 10 on the first main surface 11 side. The antireflection layer 20 was formed by using a sputtering method, and the configuration of each layer was as shown in Table 1 below.

[Table 1]

Table 1

| Layer | Refractive index | Component | Thickness [nm] |
|---|---|---|---|
| First layer (outermost layer) | Low | Silicon oxide | 87 |
| Second layer | High | Niobium oxide | 119 |
| Third layer | Low | Silicon oxide | 38 |
| Fourth layer | High | Niobium oxide | 14 |

Through the above, the glass article 100 was prepared.

The obtained glass article 100 was evaluated by the following methods.

In Example 1, the surface roughness and the color tone of the end surface 13 were measured on the short side.

In Example 2, the surface roughness and the color tone of the end surface 13 were measured on the long side.

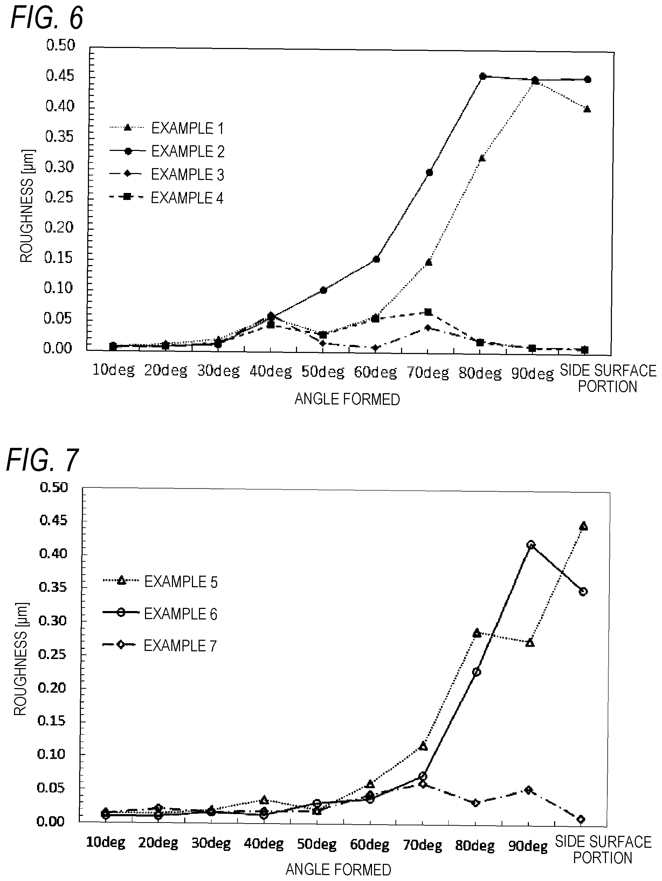

The results are shown in Tables 2 to 4 and FIG. 6.

The method for measuring the surface roughness is as follows.

The end surface 13 of the glass article 100 was measured by using a laser microscope (LEXT OLS5000 manufactured by Olympus Corporation, 50x lens in use). At this time, the glass was installed such that a perpendicular line at the measurement point on the end surface 13 coincided with an optical axis of the lens of the laser microscope.

A region of 256 $\mu$m in length × 256 $\mu$m in width was measured, the arithmetic mean roughness Ra of 10 lines spaced 5 $\mu$m apart along the entire horizontal length of a region of 50 $\mu$m in length × 256 $\mu$m in width at a vertical center of the measurement region was calculated, and the average value was used as the roughness at that measurement point. Note that, the arithmetic mean roughness Ra was defined in accordance with JIS B 0601:2.

Note that, the surface shape of the glass article in which the antireflection layer is provided on the surface of the glass follows the surface shape of the glass, and the arithmetic mean roughness on the surfaces of the glass article and the glass substantially matches each other.

The method for measuring the color tone is as follows.

In the first chamfered portion 15 of the glass article 100, a perpendicular line at a point where the angle formed between the first chamfered portion 15 and the first main surface 11 was 45° was used as a reference, white light was incident on the side surface portion 14 side at an angle of 10°, and a spectrum was obtained by using a two-dimensional spectroradiometer at an angle of 10° toward the first main surface 11 side. As a light source, an illumination having sensitivity in a visible light region was used. Specifically, a white LED illumination (OPF-S100X100W-PS manufactured by OPTEX FA CO., LTD.) was used. As a detector, a spectroradiometer ("SR-5000" manufactured by TOPCON TECHNOHOUSE CORPORATION) was used.

In the obtained data, the measurement point was defined by segmenting the image into 10 points for each pixel, and the color tone at each measurement point was calculated in the L*a*b* color system. Note that, the calculation of the L*a*b* color system conformed to JIS Z 8781-4.

(Examples 3 and 4)

In Examples 3 and 4, the glass article 100 was prepared in the same manner as in Examples 1 and 2 except that brush polishing was used to polish the end surface 13 and the side surface portion 14 was also polished. Cerium oxide was used as a polishing material used for the brush polishing.

The obtained glass article 100 was evaluated by the above methods.

In Example 3, the surface roughness and the color tone of the end surface 13 were measured on the short side.

In Example 4, the surface roughness and the color tone of the end surface 13 were measured on the long side.

The results are shown in Tables 2, 5, and 6 and FIG. 6.

[Table 2]

Table 2

|  |  | Ex. 1 | Ex. 2 | Ex. 3 | Ex. 4 |
|---|---|---|---|---|---|
| Arithmetic mean roughness Ra [$\mu$m] | Ave. ($Ra_1$) in region of greater than 0° and 40° or less | 0.02 | 0.02 | 0.02 | 0.02 |
|  | Ave. ($Ra_2$) in region of 60° or more and 80° or less | 0.18 | 0.30 | 0.02 | 0.05 |
|  | Ave. ($Ra_3$) in region of greater than 80° and side surface | 0.43 | 0.45 | 0.01 | 0.01 |
| ($Ra_2$-$Ra_1$)/($Ra_3$-$Ra_1$) | | 0.38 | 0.65 | -0.15 | -3.4 |
| Average value of measurement points at L* $\geq$ 5 in L*a*b* | L* | 21.4 | 21.6 | 14.1 | 21.1 |
|  | a* | 5.3 | 10.4 | 19.2 | 18.4 |
|  | b* | 10.8 | 14.6 | 16.0 | 27.0 |

[Table 3]

Table 3

| Example 1 | | | |
|---|---|---|---|
|  | L* | a* | b* |
| Measurement point 1 | -1.0 | 15.8 | -13.7 |
| Measurement point 2 | 11.7 | 16.4 | -0.1 |
| Measurement point 3 | 19.3 | 15.6 | 6.0 |
| Measurement point 4 | 25.1 | 5.6 | 12.3 |
| Measurement point 5 | 29.4 | -0.9 | 19.6 |
| Measurement point 6 | 25.6 | -2.5 | 17.2 |
| Measurement point 7 | 7.5 | 9.6 | -3.1 |
| Measurement point 8 | -5.7 | 7.5 | -12.0 |
| Measurement point 9 | -7.2 | -3.5 | 0.4 |
| Measurement point 10 | -7.7 | -0.8 | 0.5 |
| Average value of measurement points at L* $\geq$ 5 | 21.4 | 5.3 | 10.8 |

[Table 4]

Table 4

| Example 2 | | | |
|---|---|---|---|
| | L* | a* | b* |
| Measurement point 1 | 2.9 | 19.8 | 0.3 |
| Measurement point 2 | 21.4 | 22.9 | 23.8 |
| Measurement point 3 | 28.4 | 18.6 | 25.4 |
| Measurement point 4 | 28.8 | 5.5 | 18.4 |
| Measurement point 5 | 33.4 | -2.3 | 22.4 |
| Measurement point 6 | 28.6 | -3.2 | 17.2 |
| Measurement point 7 | 7.9 | 11.3 | -5.5 |
| Measurement point 8 | -4.6 | 6.1 | -11.1 |
| Measurement point 9 | -6.9 | 0.5 | 2.2 |
| Measurement point 10 | -8.6 | 2.0 | -7.4 |
| Average value of measurement points at $L^* \geq 5$ | 21.6 | 10.4 | 14.6 |

[Table 5]

Table 5

| Example 3 | | | |
|---|---|---|---|
| | L* | a* | b* |
| Measurement point 1 | -5.5 | 19.7 | -12.5 |
| Measurement point 2 | 10.0 | 22.3 | 9.6 |
| Measurement point 3 | 18.9 | 19.6 | 22.1 |
| Measurement point 4 | 12.1 | 16.7 | 13.8 |
| Measurement point 5 | 2.1 | 5.1 | 3.7 |
| Measurement point 6 | -1.1 | -3.6 | 4.0 |
| Measurement point 7 | -6.4 | 0.0 | -2.9 |
| Measurement point 8 | -8.6 | -6.0 | 1.8 |
| Measurement point 9 | -7.4 | -4.8 | 2.9 |
| Measurement point 10 | -9.4 | -3.2 | -3.6 |
| Average value of measurement points at $L^* \geq 5$ | 14.1 | 19.2 | 16.0 |

[Table 6]

## EP 4 620 933 A1

Table 6

| Example 4 | | | |
|---|---|---|---|
| | L* | a* | b* |
| Measurement point 1 | 1.1 | 20.2 | -0.9 |
| Measurement point 2 | 20.4 | 23.3 | 26.9 |
| Measurement point 3 | 27.3 | 17.8 | 35.9 |
| Measurement point 4 | 13.0 | 14.1 | 13.7 |
| Measurement point 5 | 3.4 | 3.2 | 4.5 |
| Measurement point 6 | 0.4 | -0.4 | 5.3 |
| Measurement point 7 | -9.0 | 2.9 | -5.5 |
| Measurement point 8 | -9.5 | 2.8 | 1.8 |
| Measurement point 9 | -8.3 | -1.5 | 1.5 |
| Measurement point 10 | -10.5 | 2.4 | -6.3 |
| Average value of measurement points at L* $\geq$ 5 | 21.1 | 18.4 | 27.0 |

As seen from the above results, in Examples 1 and 2 which are Inventive Examples, in the region where the angle formed between the first chamfered portion 15 and the first main surface 11 was greater than 0° and 40° or less, the average value $Ra_1$ of the arithmetic mean roughness Ra on the surface of the glass article 100 was 0.20 $\mu$m or less; in the region where the angle formed was 60° or more and 80° or less, the average value $Ra_2$ of the arithmetic mean roughness Ra satisfied the expression (1); and in the region where the angle formed was greater than 80° and in the side surface portion, the average value $Ra_3$ of the arithmetic mean roughness Ra was 0.30 $\mu$m or more. It can also be seen that in Examples 1 and 2, regarding the color tone of the reflected light in the L*a*b* color system, the average value of a* at the measurement points that satisfied L* $\geq$ 5 was 0 or more and 15.0 or less, and redness in the reflected light could be prevented.

On the other hand, in Examples 3 and 4 which are Comparative Examples, regarding the color tone of the reflected light in the L*a*b* color system, the average value of a* at the measurement points that satisfied L* $\geq$ 5 was greater than 15.0, and red discoloration occurred in the end portion.

In addition, the glass articles in Examples 1 and 2 had a parameter R of 22.45, which satisfies the expression (3), and therefore had excellent impact resistance at the end surface 13.

(Examples 5 and 6)

In Examples 5 and 6, as the glass 10, Dragontrail manufactured by AGC Inc. was used to prepare a glass having a substantially rectangular main surface shape with short sides of 50 mm, long sides of 150 mm, and a thickness t of 1.3 mm. The glass 10 had a flat shape having the first main surface 11 and the second main surface 12, and had a Young's modulus of 74 GPa.

The end surface 13 of the glass 10 was ground by the method illustrated in (A) of FIG. 5 to form the side surface portion 14, the first chamfered portion 15, and the second chamfered portion 16. For the grinding, diamond electrodeposited wheels #400 and #800 were used. At this time, in the curved surface shape of the first chamfered portion 15, the radius of curvature at an angle formed of 9° to 30° with the first main surface was 2.4 mm, and the radius of curvature at an angle formed of 45° was 0.2 mm. The first chamfered portion 15 had a width A of 1.48 mm and a thickness D of 0.65 mm, the second chamfered portion 16 had a width B of 0.15 mm, and the side surface portion 14 had a thickness C of 0.5 mm. That is, the parameter R represented by the above expression (1) was 23.07. The width of the region where the angle formed between the first chamfered portion 15 and the first main surface 11 was greater than 0° and 40° or less was 1.60 mm.

Next, the end surface 13 was polished in the same manner as in Examples 1 and 2, and finally, the antireflection layer 20 was formed on the surface of the glass 10 on the first main surface 11 side.

Through the above, the glass article 100 was prepared.

The obtained glass article 100 was evaluated by the above methods.

In Example 5, the surface roughness and the color tone of the end surface 13 were measured on the short side.

In Example 6, the surface roughness and the color tone of the end surface 13 were measured on the long side.

The results are shown in Tables 7 to 9 and FIG. 7.

The method for measuring the surface roughness is the same as in Examples 1 to 4.

The method for measuring the color tone is the same as in Examples 1 to 4 except that the measurement point was defined by segmenting the image into 9 points for each pixel, and the color tone at each measurement point was calculated in the L*a*b* color system, or the color tone at each measurement point was calculated in the L*a*b* color system.

(Example 7)

In Example 7, the glass article 100 was prepared in the same manner as in Examples 1 and 2 except that brush polishing was used to polish the end surface 13 and the side surface portion 14 was also polished. Cerium oxide was used as a polishing material used for the brush polishing.

In Example 7, the surface roughness and the color tone of the end surface 13 were measured on the long side.

The results are shown in Tables 7 and 10 and FIG. 7.

[Table 7]

Table 7

| | | Ex. 5 | Ex. 6 | Ex. 7 |
|---|---|---|---|---|
| Arithmetic mean roughness Ra [μm] | Ave. ($Ra_1$) in region of greater than 0° and 40° or less | 0.02 | 0.01 | 0.02 |
| | Ave. ($Ra_2$) in region of 60° or more and 80° or less | 0.16 | 0.11 | 0.05 |
| | Ave. ($Ra_3$) in region of greater than 80° and side surface | 0.36 | 0.39 | 0.03 |
| ($Ra_2$-$Ra_1$)/($Ra_3$-$Ra_1$) | | 0.39 | 0.27 | 2.0 |
| Average value of measurement points at $L^* \geq 5$ in L*a*b* | L* | 23.9 | 22.2 | 12.9 |
| | a* | 5.3 | 5.7 | 15.4 |
| | b* | 12.1 | 11.1 | 12.9 |

[Table 8]

Table 8

| Example 5 | | | |
|---|---|---|---|
| | L* | a* | b* |
| Measurement point 1 | 4.8 | 7.2 | 1.2 |
| Measurement point 2 | 17.5 | 16.8 | 13.6 |
| Measurement point 3 | 29.0 | 6.2 | 19.4 |
| Measurement point 4 | 30.0 | 4.1 | 13.9 |
| Measurement point 5 | 27.2 | -2.2 | 9.4 |
| Measurement point 6 | 5.8 | 9.1 | -3.9 |
| Measurement point 7 | -7.0 | -0.5 | -0.8 |
| Measurement point 8 | -14.1 | 5.4 | -5.3 |
| Measurement point 9 | -14.0 | 7.1 | -7.1 |
| Average value of measurement points at $L^* \geq 5$ | 23.9 | 5.3 | 12.1 |

[Table 9]

Table 9

| Example 6 | | | |
|---|---|---|---|
| | L* | a* | b* |
| Measurement point 1 | 11.9 | 16.6 | 8.6 |
| Measurement point 2 | 25.7 | 7.9 | 20.9 |
| Measurement point 3 | 28.0 | 4.6 | 12.4 |
| Measurement point 4 | 26.5 | 0.4 | 9.7 |
| Measurement point 5 | 12.2 | 4.9 | 0.3 |
| Measurement point 6 | -3.3 | 1.2 | -1.4 |
| Measurement point 7 | -12.6 | -1.1 | -3.5 |
| Measurement point 8 | -14.2 | -0.3 | -0.2 |
| Measurement point 9 | -13.2 | 3.5 | -5.0 |
| Average value of measurement points at L* ≥ 5 | 22.2 | 5.7 | 11.1 |

[Table 10]

Table 10

| Example 7 | | | |
|---|---|---|---|
| | L* | a* | b* |
| Measurement point 1 | 13.1 | 16.7 | 10.7 |
| Measurement point 2 | 13.9 | 15.5 | 12.3 |
| Measurement point 3 | 11.5 | 13.9 | 17.0 |
| Measurement point 4 | -3.9 | 2.8 | 4.8 |
| Measurement point 5 | -14.0 | 2.8 | -3.7 |
| Measurement point 6 | -14.2 | 0.9 | 1.3 |
| Measurement point 7 | -14.0 | -1.0 | 1.0 |
| Measurement point 8 | -11.8 | -4.3 | 4.5 |
| Measurement point 9 | -14.2 | 3.4 | -3.9 |
| Average value of measurement points at L* ≥ 5 | 12.9 | 15.4 | 12.9 |

As seen from the above results, in Examples 5 and 6 which are Inventive Examples, in the region where the angle formed between the first chamfered portion 15 and the first main surface 11 was greater than 0° and 40° or less, the average value $Ra_1$ of the arithmetic mean roughness Ra on the surface of the glass article 100 was 0.20 $\mu$m or less; in the region where the angle formed was 60° or more and 80° or less, the average value $Ra_2$ of the arithmetic mean roughness Ra satisfied the expression (1); in the region where the angle formed was greater than 80° and in the side surface portion, the average value $Ra_3$ of the arithmetic mean roughness Ra was 0.30 $\mu$m or more; and regarding the color tone of the reflected light in the L*a*b* color system, the average value of a* at the measurement points that satisfied L* ≥ 5 was 0 or more and 15.0 or less, and redness in the reflected light could be prevented.

On the other hand, in Example 7 which is a Comparative Example, regarding the color tone of the reflected light in the L*a*b* color system, the average value of a* at the measurement points that satisfied L* ≥ 5 was greater than 15.0, and red discoloration occurred in the end portion.

In addition, the glass articles in Examples 5 and 6 had a parameter R of 23.07, which satisfies the expression (3), and therefore had excellent impact resistance at the end surface 13.

Table 11 shows, for the glass articles in Examples 1 to 4 prepared above, the average value of the arithmetic mean roughness Ra on the surface of the glass article in the region where the angle formed between the first chamfered portion and the first main surface is greater than 0° and 40° or less, the average value of the arithmetic mean roughness Ra on the surface of the glass article in the region where the angle formed between the first chamfered portion and the first main surface is greater than 40° and 80° or less, and the average value of the arithmetic mean roughness Ra on the surface of the glass article in the region where the angle formed between the first chamfered portion and the first main surface is greater than 80° and in the side surface portion.

[Table 11]

Table 11

| | | Ex. 1 | Ex. 2 | Ex. 3 | Ex. 4 |
|---|---|---|---|---|---|
| Arithmetic mean roughness Ra [μm] | Ave. in region of greater than 0° and 40° or less | 0.02 | 0.02 | 0.02 | 0.02 |
| | Ave. in region of greater than 40° and 80° or less | 0.14 | 0.25 | 0.02 | 0.04 |
| | Ave. in region of greater than 80° and side surface | 0.43 | 0.45 | 0.01 | 0.01 |
| Average value of measurement points at $L^* \geq$ 5 in $L^*a^*b^*$ | $L^*$ | 21.4 | 21.6 | 14.1 | 21.1 |
| | $a^*$ | 5.3 | 10.4 | 19.2 | 18.4 |
| | $b^*$ | 10.8 | 14.6 | 16.0 | 27.0 |

Although the present invention has been described in detail with reference to specific embodiments, it is apparent to those skilled in the art that various changes and modifications can be made without departing from the spirit and scope of the present invention. The present application is based on a Japanese Patent Application (Japanese Patent Application No. 2022-185227) filed on November 18, 2022, the contents of which are incorporated herein by reference.

REFERENCE SIGNS LIST

1 steering shaft
2 in-vehicle display device
3 display panel
100 glass article
10 glass
11 first main surface
12 second main surface
13 end surface
14 side surface portion
15 first chamfered portion
16 second chamfered portion
20 antireflection layer
40 rotary grindstone (for grinding)
50 rotary grindstone (for polishing)
t thickness

**Claims**

1. A glass article comprising:

   a first main surface;
   a second main surface; and
   an end surface connecting the first main surface and the second main surface, wherein
   the end surface includes a side surface portion and a first chamfered portion having a curved surface shape
   connecting the side surface portion and the first main surface,

the first main surface and the first chamfered portion include an antireflection layer,

in a region where an angle formed between the first chamfered portion and the first main surface is greater than 0° and 40° or less, an average value $Ra_1$ of an arithmetic mean roughness Ra on a surface of the glass article is 0.20 $\mu$m or less,

in a region where the angle formed between the first chamfered portion and the first main surface is greater than 80° and in the side surface portion, an average value $Ra_3$ of the arithmetic mean roughness Ra on the surface of the glass article is 0.30 $\mu$m or more, and

in a region where the angle formed between the first chamfered portion and the first main surface is 60° or more and 80° or less, an average value $Ra_2$ of the arithmetic mean roughness Ra on the surface of the glass article satisfies the following expression (1).

$$0.2 \leq (Ra_2 - Ra_1)/(Ra_3 - Ra_1) \leq 0.8 \qquad (1)$$

2. The glass article according to claim 1, wherein the first chamfered portion has a width of 0.5 mm or more and 5.0 mm or less.

3. The glass article according to claim 1, wherein the region where the angle formed between the first chamfered portion and the first main surface is greater than 0° and 40° or less has a width of 0.43 mm or more and 4.8 mm or less.

4. The glass article according to claim 1, wherein a relationship between an arithmetic mean roughness $Ra_{40°}$ on the surface of the glass article at a point where the angle formed between the first chamfered portion and the first main surface is 40°, an arithmetic mean roughness $Ra_{60°}$ on the surface of the glass article at a point where the angle formed between the first chamfered portion and the first main surface is 60°, and an arithmetic mean roughness $Ra_{80°}$ on the surface of the glass article at a point where the angle formed between the first chamfered portion and the first main surface is 80° is $Ra_{40°} < Ra_{60°} < Ra_{80°}$.

5. The glass article according to claim 1, wherein regarding a color tone of reflected light in an L*a*b* color system at each measurement point of the first chamfered portion, which is measured by using the following measurement method, an average value of a* at the measurement points that satisfy $L^* \geq 5$ is 0 or more and 15.0 or less,

(measurement method)

in the first chamfered portion, a perpendicular line at a point where the angle formed between the first chamfered portion and the first main surface is 45° is used as a reference, white light is incident on a side surface portion side at an angle of 10°, and an image is obtained by using a two-dimensional spectroradiometer at an angle of 10° toward a first main surface side, and in the image, the measurement point is defined by segmenting the image for each pixel, and the color tone at each measurement point is calculated in the L*a*b* color system.

6. The glass article according to claim 1, wherein a color tone of reflected light from the first main surface satisfies -3 < a* < 3 and -3 < b* < 3 in an L*a*b* color system.

7. The glass article according to claim 1, wherein

the end surface includes the side surface portion and a second chamfered portion connecting the side surface portion and the second main surface, and

a parameter R defined by the following expression (2) satisfies an expression (3):

$$R = 0.38 \cdot E_{cg} - A/t - 2.61 \cdot B/t + 4.38 \cdot C/t - 10.6 \cdot D/t \qquad (2)$$

$$R \leq 23.58 \qquad (3)$$

in the expression (2), $E_{cg}$ represents a Young's modulus (GPa) of the glass article, A represents a width (mm) of the first chamfered portion, B represents a width (mm) of the second chamfered portion, C represents a thickness (mm) of the side surface portion, D represents a thickness (mm) of the first chamfered portion, and t represents a thickness (mm) of the glass article.

8. The glass article according to claim 7, wherein

the width A of the first chamfered portion is 2.0 mm or less,
a glass article thickness ratio (A/t), which is a ratio of the width A of the first chamfered portion to the thickness of the glass article, is 0.77 or more,
the width B of the second chamfered portion is 1.0 mm or more and 2.0 mm or less,
the thickness C of the side surface portion is 0.25 mm or more,
a glass article thickness ratio (C/t), which is a ratio of the thickness C of the side surface portion to the thickness of the glass article, is 0.6 or less, and
a glass article thickness ratio (D/t), which is a ratio of the thickness D of the first chamfered portion to the thickness of the glass article, is 0.2 or more and 0.7 or less.

9.  The glass article according to claim 1, wherein the antireflection layer comprises a metal oxide film, and is formed by alternately laminating a high refractive index layer having a refractive index of 1.9 or more at a wavelength of 550 nm and a low refractive index layer having a refractive index of 1.6 or less at a wavelength of 550 nm.

10. The glass article according to claim 9, wherein the number of the low refractive index layer is one or more and six or less.

11. The glass article according to claim 1, wherein in the region where the angle formed between the first chamfered portion and the first main surface is greater than 0° and 40° or less, the average value $Ra_1$ of the arithmetic mean roughness Ra on the surface of the glass article is 0.15 $\mu$m or less.

12. The glass article according to claim 1, wherein in the region where the angle formed between the first chamfered portion and the first main surface is greater than 0° and 40° or less, the average value $Ra_1$ of the arithmetic mean roughness Ra on the surface of the glass article is 0.10 $\mu$m or less.

13. The glass article according to claim 1, wherein in the region where the angle formed between the first chamfered portion and the first main surface is greater than 80° and in the side surface portion, the average value $Ra_3$ of the arithmetic mean roughness Ra on the surface of the glass article is 0.35 $\mu$m or more.

14. A display cover glass comprising:

    the glass article according to any one of claims 1 to 13; and
    a printed layer on a second main surface side.

15. The display cover glass according to claim 14, further comprising:
    an antiglare layer on a first main surface side.

16. The display cover glass according to claim 14, further comprising:
    an antifouling layer on or above the antireflection layer.

17. A display device comprising:

    the display cover glass according to claim 14; and
    a display, wherein
    the second main surface side is attached to the display.

18. An in-vehicle display device comprising:

    the display cover glass according to claim 14; and
    a display, wherein
    the second main surface side is attached to the display.

FIG. 1

FIG. 2

*FIG. 3*

*FIG. 4*

# FIG. 5

(A)

(B)

FIG. 6

FIG. 7

## INTERNATIONAL SEARCH REPORT

| International application No. |
| --- |
| **PCT/JP2023/041250** |

**A. CLASSIFICATION OF SUBJECT MATTER**

*C03C 19/00*(2006.01)i; *C03C 17/34*(2006.01)i; *G09F 9/00*(2006.01)i
FI: C03C19/00 Z; C03C17/34 Z; G09F9/00 302

According to International Patent Classification (IPC) or to both national classification and IPC

**B. FIELDS SEARCHED**

Minimum documentation searched (classification system followed by classification symbols)

C03C15/00-23/00; G09F9/00

Documentation searched other than minimum documentation to the extent that such documents are included in the fields searched

Published examined utility model applications of Japan 1922-1996
Published unexamined utility model applications of Japan 1971-2024
Registered utility model specifications of Japan 1996-2024
Published registered utility model applications of Japan 1994-2024

Electronic data base consulted during the international search (name of data base and, where practicable, search terms used)

**C. DOCUMENTS CONSIDERED TO BE RELEVANT**

| Category* | Citation of document, with indication, where appropriate, of the relevant passages | Relevant to claim No. |
| --- | --- | --- |
| A | WO 2021/161879 A1 (AGC INC.) 19 August 2021 (2021-08-19)<br>entire text | 1-18 |
| A | WO 2017/208995 A1 (AGC INC.) 07 December 2017 (2017-12-07)<br>entire text | 1-18 |
| A | JP 2020-140077 A (AGC INC.) 03 September 2020 (2020-09-03)<br>entire text | 1-18 |
| A | JP 2019-064874 A (AGC INC.) 25 April 2019 (2019-04-25)<br>entire text | 1-18 |

☐ Further documents are listed in the continuation of Box C.    ☑ See patent family annex.

| | |
| --- | --- |
| * Special categories of cited documents:<br>"A" document defining the general state of the art which is not considered to be of particular relevance<br>"D" document cited by the applicant in the international application<br>"E" earlier application or patent but published on or after the international filing date<br>"L" document which may throw doubts on priority claim(s) or which is cited to establish the publication date of another citation or other special reason (as specified)<br>"O" document referring to an oral disclosure, use, exhibition or other means<br>"P" document published prior to the international filing date but later than the priority date claimed | "T" later document published after the international filing date or priority date and not in conflict with the application but cited to understand the principle or theory underlying the invention<br>"X" document of particular relevance; the claimed invention cannot be considered novel or cannot be considered to involve an inventive step when the document is taken alone<br>"Y" document of particular relevance; the claimed invention cannot be considered to involve an inventive step when the document is combined with one or more other such documents, such combination being obvious to a person skilled in the art<br>"&" document member of the same patent family |

| Date of the actual completion of the international search | Date of mailing of the international search report |
| --- | --- |
| **18 January 2024** | **30 January 2024** |

| Name and mailing address of the ISA/JP | Authorized officer |
| --- | --- |
| **Japan Patent Office (ISA/JP)**<br>**3-4-3 Kasumigaseki, Chiyoda-ku, Tokyo 100-8915**<br>**Japan** | |
| | Telephone No. |

Form PCT/ISA/210 (second sheet) (July 2022)

## INTERNATIONAL SEARCH REPORT
### Information on patent family members

| Patent document cited in search report | | | Publication date (day/month/year) | Patent family member(s) | | | Publication date (day/month/year) |
|---|---|---|---|---|---|---|---|
| WO | 2021/161879 | A1 | 19 August 2021 | US | 2022/0373716 | A1 | |
| | | | | the whole document | | | |
| | | | | EP | 4105189 | A1 | |
| | | | | CN | 115087628 | A | |
| | | | | TW | 202132820 | A | |
| WO | 2017/208995 | A1 | 07 December 2017 | US | 2019/0094604 | A1 | |
| | | | | the whole document | | | |
| | | | | DE | 112017002734 | T | |
| | | | | CN | 109219842 | A | |
| | | | | TW | 201743117 | A | |
| JP | 2020-140077 | A | 03 September 2020 | US | 2020/0277222 | A1 | |
| | | | | the whole document | | | |
| | | | | DE | 102020001405 | A | |
| | | | | CN | 111627316 | A | |
| JP | 2019-064874 | A | 25 April 2019 | US | 2019/0101787 | A1 | |
| | | | | the whole document | | | |
| | | | | DE | 102018007727 | A | |
| | | | | CN | 109597233 | A | |
| | | | | CN | 209070264 | U | |

Form PCT/ISA/210 (patent family annex) (July 2022)

**REFERENCES CITED IN THE DESCRIPTION**

*This list of references cited by the applicant is for the reader's convenience only. It does not form part of the European patent document. Even though great care has been taken in compiling the references, errors or omissions cannot be excluded and the EPO disclaims all liability in this regard.*

**Patent documents cited in the description**

- WO 2021161879 A
- WO 2015108076 A
- WO 2013031548 A
- JP 2022 A
- JP 185227 A